**Europäisches Patentamt**

**European Patent Office**

**Office européen des brevets**

(19)

(11) Veröffentlichungsnummer: **0 045 509**
**B1**

(12) **EUROPÄISCHE PATENTSCHRIFT**

(45) Veröffentlichungstag der Patentschrift:
**18.12.85**

(51) Int. Cl.⁴: **G 01 R 33/02**

(21) Anmeldenummer: **81106071.4**

(22) Anmeldetag: **03.08.81**

(54) **Anordnung zur Bestimmung der Stärke eines Magnetfeldes, z.B. des Erdfeldes.**

(30) Priorität: **04.08.80 DE 3029532**

(43) Veröffentlichungstag der Anmeldung:
**10.02.82 Patentblatt 82/6**

(45) Bekanntmachung des Hinweises auf die Patenterteilung:
**18.12.85 Patentblatt 85/51**

(84) Benannte Vertragsstaaten:
**AT BE CH FR GB IT LI NL SE**

(56) Entgegenhaltungen:
**DE - A - 2 245 191**
**DE - A - 2 353 039**
**DE - A - 2 823 231**
**DE - A - 2 933 129**
**DE - A - 2 949 815**
**US - A - 3 628 132**

**IEEE Transactions on magnetics, vol. MAG-8, no. 2, juin 1972, NEW YORK (US), D.C. SCOUTEN: "Sensornoise in low-level flux-gate magnetometers", Seiten 223-231**

(73) Patentinhaber: **Siemens Aktiengesellschaft, Berlin und München Wittelsbacherplatz 2, D-8000 München 2 (DE)**

(72) Erfinder: **Metzner, Uwe, Theodolindenstrasse 49, D-8000 München 90 (DE)**
Erfinder: **Thilo, Peer, Dr.-Ing., Buchhierlstrasse 19, D-8000 München 71 (DE)**

## Beschreibung

Die Erfindung betrifft eine Anordnung zur Bestimmung der Feldstärke eines Magnetfeldes gemäss dem Oberbegriff des Anspruches 1.

Zur Bestimmung eines Magnetfeldes, insbesondere des Erdfeldes, werden häufig Magnetsonden benützt. Dabei wird die Feldstärke des relativ schwachen Erdfeldes gemessen. Aus der Anordnung zweier Magnetsonden, die in einer horizontalen Ebene beispielsweise senkrecht zueinander stehen, lässt sich je eine Komponente des horizontal einwirkenden Erdfeldes messen. Aus dem Vergleich der beiden Feldstärkenkomponenten lässt sich mit trigonometrischen Methoden die Magnetfeldrichtung errechnen und anzeigen. Dabei kann zur Messung der Magnetfeldstärke folgender Effekt ausgenutzt werden: Eine Magnetsonde, die einen Eisenkern, eine Primär- und Sekundärwicklung aufweist, wird mit einem Erregerwechselstrom beaufschlagt. Der durch die Primärwicklung fliessende Erregerwechselstrom erzeugt ein inneres Magnetfeld, das sich mit dem äusseren Magnetfeld überlagert. Die in der Sekundärwicklung induzierte Spannung weist aufgrund des äusseren Magnetfeldes asymmetrische Amplituden auf. Die unterschiedlichen Amplituden beider Halbwellen sind ein Mass für die zu messende Feldstärke. Mit geeigneten Auswerteinrichtungen lassen sich die Amplitudendifferenzen ermitteln und zur Anzeige bringen.

Beispielsweise beschreibt die DE-OS 2 353 039 eine Messanordnung für die Winkelstellung eines Magnetfeldes, mit der es möglich ist, die Richtung eines Magnetfeldes mit einer Magnetsonde zu bestimmen. Dabei weist ein Messgeber, der insbesondere als Erdfeldsonde ausgebildet ist, zwei zueinander senkrecht stehende Sekundärwicklungen auf. Zur Magnetisierung der Erdfeldsonde sind zwei Erregerwicklungen notwendig, die mit einem Wechselstrom jeweils erregt werden, so dass an den Sekundärwicklungen Ausgangssignale anstehen, die zumindest Anteile aufweisen, deren Amplituden sich mit dem Sinus bzw. Kosinus des Stellungswinkels ändern. Ferner weist diese Messanordnung zwei RC-Brückenschaltungen zur Bildung von gegensinnig phasenbeweglichen Signalen sowie eine Auswerteschaltung, in welcher nach Frequenzteilung der Signale aus deren Phasenwinkel der Stellungswinkel und damit die Magnetfeldrichtung bestimmt wird.

Ein derartiges Messverfahren hat aber verschiedene Nachteile. Die Nichtlinearität des Eisenkernes führt zur Verzerrung der induzierten Spannung, so dass die Ausgangsspannung eine signifikante andere Kurvenform als der treibende Erregerstrom aufweist. Insbesondere wird eine grosse Zahl von aussteuerungsabhängigen Oberwellen erzeugt, die sich zu unterschiedlich grossen Spitzenspannungen überlagern und so den genauen Vergleich beider Halbwellenamplituden beeinträchtigen. Um diesen Effekt klein zu halten, sind aufwendige Filter und Phasendrehglieder erforderlich, um aus den Amplitudenanteilen die Phasenwinkel zu ermitteln. Derartige Filter sind kompliziert und aufwendig aufgebaut, um nur die zweite harmonische Schwingung durchzulassen, damit bei einem schwachen Erdfeld zuverlässige Messwerte erzielt werden können. Zudem benötigt bei einer derartigen Messanordnung die Magnetfeldsonde jeweils Primär- und Sekundärwicklungen zum Anlegen einer Erregerwechselspannung und zum Abgreifen des Ausgangssignals. Das erzeugte Signal ist eine feldstärkenabhängige Spannung, die aber im allgemeinen zur weiteren Bearbeitung mit einer zusätzlichen Einrichtung digitalisiert werden muss.

Aus der DE-OS 2 245 191 ist eine Vorrichtung zum Messen von Magnetfeldern mittels Frequenzmessung bekannt. Dabei wird ein Oszillator mit einem die Frequenz bestimmenden Schaltkreis mit einer Induktivität benutzt. Diese ist mit einem magnetischen Kern im zu messenden Magnetfeld angeordnet. Zur Kompensation von thermischen Einflüssen, die eine Frequenzwanderung verursachen, und zur Bildung eines Bezugwertes wird ein zweiter, ähnlicher Oszillator mit einer weiteren Induktivität, die nicht dem zu messenden Magnetfeld ausgesetzt ist, angeordnet und mit einer Differentialanordnung die Magnetfeldstärke ermittelt und angezeigt. Diese Vorrichtung wird in Verbindung mit einem Massenspektrometer benutzt. Dabei werden hohe Feldstärken von beispielsweise 2 bis 10 Kilogauss gemessen. Für die Bestimmung der Feldstärke und der Feldrichtung sehr schwacher Magnetfelder, wie beispielsweise des Erdfeldes, ist eine solche Vorrichtung nicht geeignet. Die Nichtlinearität des Eisenkernes führt auch bei dieser Messvorrichtung zu Verzerrungen. Zudem müsste auch der zweite frequenzbestimmende Schaltkreis mit dem zweiten Oszillator exakt gleich aufgebaut sein, wie der erste Oszillator, um genaue Messergebnisse erzielen zu können. Ferner müsste die Induktivität des zweiten Oszillators dem Einfluss eines äusseren Magnetfeldes entzogen werden, um einen Bezugswert zu erhalten. Zur Ermittlung der Magnetfeldrichtung wäre eine derartige Anordnung doppelt vorzusehen. Dies würde zu einem aufwendigen und komplizierten Aufbau, nämlich vier gleichartigen Magnetsonden und Oszillatoren, davon zwei abgeschirmt, führen. Dabei sind thermische Einflüsse, die ein unterschiedliches Verhalten der verschiedenen obengenannten Schaltungselemente verursachen können, nicht ausgeschlossen.

In der älteren Anmeldung, DE-OS 2 933 129, veröffentlicht am 26.02.81, ist ein Messverfahren zur Bestimmung der Magnetfeldstärke beschrieben. Dort ist eine Schaltungsanordnung zum Messen eines Magnetfeldes, insbesondere des Erdmagnetfeldes, beschrieben, wobei zwei Saturationskern-Oszillatoren vorgesehen sind, um aus dem Frequenzunterschied der beiden Oszillatoren das Erdmagnetfeld (Feldstärke) zu bestimmen. Die beiden Spulen der Oszillatoren sind bei dieser Schaltungsanordnung gegensinnig geschaltet und parallel angeordnet. Dadurch wird durch die Änderung des äusseren Magnetfeldes die Frequenz des einen Oszillators herauf- und die Frequenz des anderen Oszillators heruntergesetzt. Aus dieser Frequenzdifferenz wird das Magnetfeld, d.h. die Feldstärke, bestimmt. Da bei dieser Messanordnung Temperatureinflüsse die Messung und damit die Messgenauigkeit erheblich beeinflussen können, sind zusätzlich verschiedene aufwendige Massnahmen zur Temperaturkompensation notwendig. Zum Beispiel sind deshalb ein thermostabiles Gehäuse aus nicht magnetischem Material, das Aufheizen auf eine konstante Temperatur, Kondensatoren mit geringen Temperaturkoeffizienten bei dieser Anordnung vorgesehen.

Aufgabe der Erfindung ist es daher, eine Anordnung der oben beschriebenen Art zur Bestimmung der Magnetfeldstärke zu schaffen, die frei von linearen Verzerrungen durch den Eisenkern der Magnetsonde und unbeeinflusst von Temperatureinflüssen ist. Dabei soll mit einem geringen schaltungstechnischen Aufwand und einfachen Bauelementen eine Messanordnung mit sehr hoher Messgenauigkeit geschaffen werden. Diese Aufgabe wird gemäss den Merkmalen im Hauptanspruch gelöst.

Zur Bestimmung der Magnetfeldstärke weist die Magnetfeldsonde eine Wicklung auf, die die frequenzbestimmende Induktivität eines einzigen Oszillatorschaltkreises ist. Zur abwechselnden Vormagnetisierung des Eisenkernes der Magnetsonde wird eine Erregerspannung an die Magnetsondenwicklung gelegt. Dabei wird mit einem taktgesteuerten Schaltelement an die Wicklung als Erregerspannung eine Gleichspannung mit wechselnder Polarität angeschaltet, die eine abwechselnde Vormagnetisierung des Eisenkernes der Sonde bewirkt und damit ein inneres Magnetfeld erzeugt. Die Induktivität der Magnetsondenwicklung ist einerseits von der abwechselnden Vormagnetisierung (inneres Magnetfeld) und anderseits vom äusseren Magnetfeld, das dem inneren Magnetfeld überlagert ist, abhängig. Ein äusseres Magnetfeld bewirkt eine Änderung der Vormagnetisierung und damit eine Änderung der Induktivität, die dadurch die Frequenz des Oszillators einmal erhöht und das andere Mal erniedrigt, so dass besagter Oszillator zwei unterschiedliche Frequenzen liefert. Mit einem weiteren Schaltelement, das synchron zum ersten Schaltelement gesteuert, d.h. von einem Taktgenerator beaufschlagt ist, werden die unterschiedlichen Frequenzen abwechselnd vom Oszillatorschaltkreis jeweils einem Eingang einer Messeinrichtung zugeführt. Mit einem nachgeschalteten Subtrahierer wird die Frequenzdifferenz ermittelt und als proportionale Grösse der Feldstärke von einer nachgeordneten Anzeigeeinrichtung angezeigt.

Mit der erfindungsgemässen Anordnung werden störende Einflüsse wie Nichtlinearität des Eisenkernes, Temperaturschwankungen, ungleiches Verhalten zweier Magnetsondenkerne und zweier Oszillatoren vermieden, weil nur eine Magnetsonde, nur eine Wicklung (Induktivität) und nur ein Oszillator notwendig ist, um die Feldstärke zu bestimmen. Mit dieser Anordnung wird auch der Grundwert der Oszillatorfrequenz eliminiert, so dass die Nichtlinearität des Eisenkernes keinen Einfluss auf die Messgenauigkeit hat. Bei der erfindungsgemässen Anordnung ist auch keine weitere Bezugsgrösse erforderlich.

In einer vorteilhaften Weiterbildung der Erfindung wird diese Anordnung zur Bestimmung der Magnetfeldrichtung genützt. Hierbei weist die Magnetfeldsonde in an sich bekannter Weise zwei in einem bestimmten Winkel, vorzugsweise senkrecht, zueinander stehende Schenkel mit jeweils einer Wicklung auf. Mit einer derartig ausgebildeten Magnetsonde, die horizontal angeordnet ist, lassen sich die Feldstärken zweier senkrecht zueinander stehenden Feldvektoren ermitteln. Dabei sind zwei Oszillatoren vorgesehen. Mit einem ersten Oszillator und dessen frequenzbestimmender erster Wicklung wird die Feldstärke der einen Feldkomponente aus der Frequenzdifferenz des ersten Oszillators und mit einem zweiten Oszillator und dessen frequenzbestimmender zweiter Wicklung wird die Feldstärke der zweiten Feldkomponente aus der Frequenzdifferenz des zweiten Oszillators ermittelt. Aus den Feldstärken beider Feldkomponenten wird mit einer Einrichtung aufgrund trigonometrischer Beziehungen die Richtung des Magnetfeldes ermittelt und in einer nachgeschalteten Anzeigeeinrichtung angezeigt.

Bei dieser Anordnung wird mit einem Schaltelement, das von einem Taktgenerator gesteuert ist, die rechteckförmige Erregerspannung abwechselnd an eine der beiden Wicklungen der beiden Oszillatorschaltkreise angelegt. Mit einem weiteren Schaltelement, das synchron zum Schaltelement für die periodische Umschaltung der Gleichspannung ebenfalls vom Taktgenerator gesteuert wird, werden die am Ausgang des ersten Oszillatorschaltkreises auftretenden Frequenzen abwechselnd an jeweils einen von zwei Eingängen einer ersten dafür vorgesehenen Frequenzmesseinrichtung und die am Ausgang des zweiten Oszillatorschaltkreises auftretenden Frequenzen abwechselnd an jeweils einen von zwei Eingängen einer zweiten Frequenzmesseinrichtung gelegt. Jeder Frequenzmesseinrichtung ist ein Subtrahierer nachgeschaltet, der jeweils die Frequenzdifferenz ermittelt und diese Frequenzdifferenzen des ersten Oszillatorschaltkreises und des zweiten Oszillatorschaltkreises einem ersten Mikrocomputer zuführt, der aus diesen Frequenzdifferenzen, die der jeweiligen Feldstärke entsprechen, die Magnetfeldrichtung ermittelt. Mit einer nachgeordneten Anzeigeeinrichtung wird die Magnetfeldrichtung angezeigt.

In vorteilhafter Weise kann die Schaltungsanordnung so aufgebaut sein, dass die vier zu messenden Frequenzen mit digitalen Zählern gemessen werden. Dabei ist es zweckmässig, einen handelsüblichen Mikrocomputer (z.B. Siemens SAB 8748C) vorzusehen, der unter anderem die Taktsteuerung der Schaltelemente, das Ansteuern der digitalen Zähler und die Differenzbildung aus den gemessenen Frequenzen vornimmt. Zum anderen kann der Mikrocomputer die Richtung der Feldlinien aufgrund trigonometrischer Beziehungen aus den ermittelten Frequenzdifferenzbeträgen berechnen und anzeigen. Die Anzeigeeinrichtung kann so ausgestaltet sein, dass sie ähnlich wie ein Kompass mit einer Magnetnadel die Nordrichtung anzeigt. Ist beispielsweise eine solche Magnetsonde in einem ortsveränderlichen Fahrzeug angeordnet, so kann die Anzeigeeinrichtung so ausgestaltet sein, dass der Richtungswinkel des Fahrzeuges bezüglich der Nordrichtung angezeigt wird. Anhand der Zeichnungen sollen Ausführungsbeispiele sowie das Verfahren näher erläutert werden.

Es zeigen:

Fig. 1 die Induktivität der Sonde in Abhängigkeit der Gleichstromvormagnetisierung,

Fig. 2 eine Schaltungsanordnung zur Ermittlung der Feldstärke,

Fig. 3 eine Schaltungsanordnung zur Ermittlung der Feldrichtung,

Fig. 4 eine Schaltungsanordnung zur Ermittlung der Feldrichtung mit digitalen Zählern und einem Mikrocomputer.

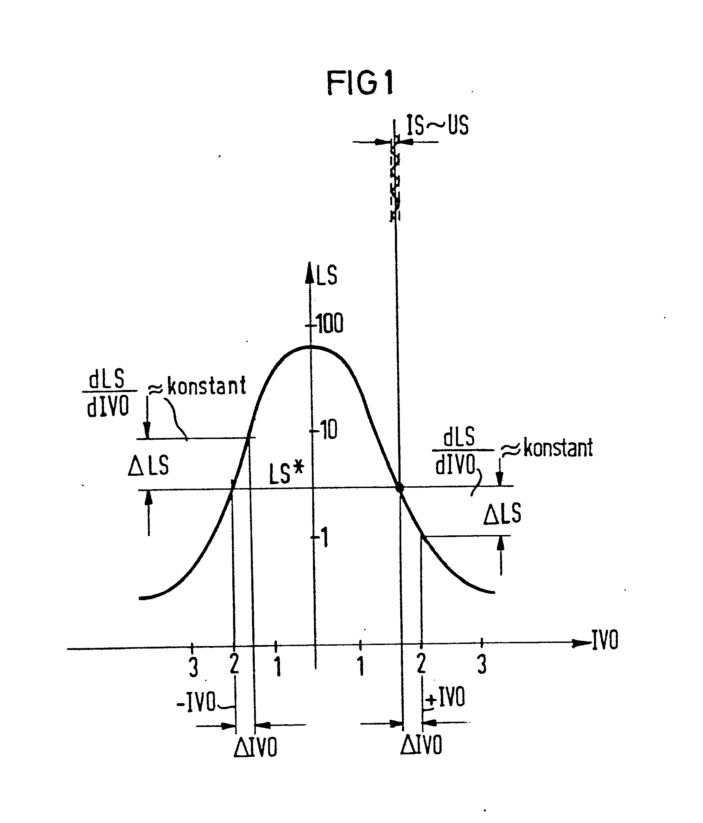

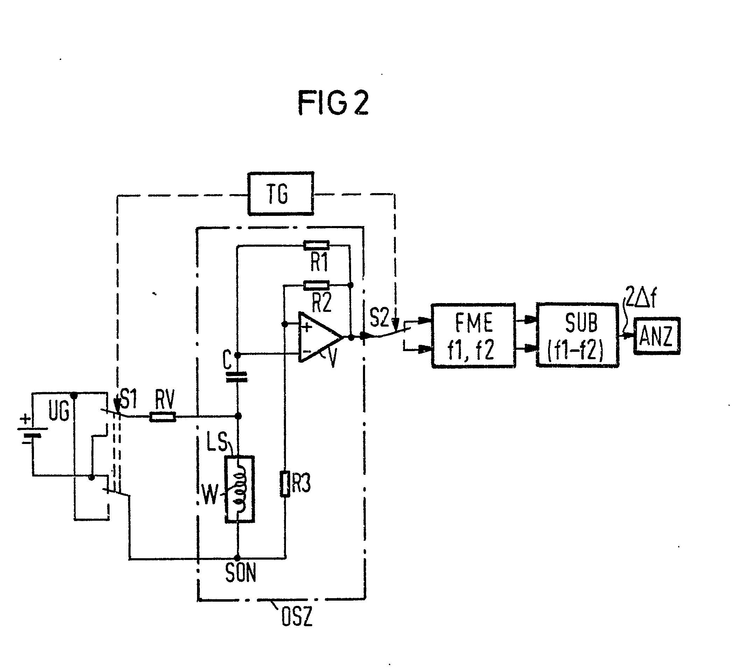

Wie in Fig. 1 veranschaulicht, liegt bei hinreichend kleiner Wechselspannung US an der Sonde SON die wirksame Induktivität LS* vor. Das äussere Magnetfeld bewirkt eine Änderung $\Delta I$ des Vormagnetisierungsgleichstromes IV0. Bei hinreichend kleiner Gleichstromänderung $\Delta I$ des Vormagnetisierungsgleichstroms ist dLS/dIV0 annähernd konstant. Damit wird bei dem positiven Vormagnetisierungsstrom $+IV0 = IV0 + \Delta I$ die Induktivität LS* durch das äussere Feld um $\Delta$LS verkleinert und bei dem negativen Vormagnetisierungsstrom $-IV0 = IV0 - \Delta I$ die Induktivität LS* am $\Delta$LS vergrössert. Ist die Induktivität LS der Magnetsonde SON nun frequenzbestimmendes Glied eines Oszillators OSZ (wie in Fig. 2, 3 und 4), so lässt sich die abwechselnd höhere und niedrigere Induktivität und damit die abwechselnd höhere und niedrigere Frequenz f1 und f2 des Oszillators OSZ messen und hieraus die äussere Feldstärke ermitteln. Wenn die Änderung der Induktivität $\Delta L$ sehr klein gegenüber der wirksamen Sondeninduktivität LS* ist ($\Delta L \ll LS^*$), kann man die entsprechenden Schwingungsfrequenzen näherungsweise durch

$$f1 = f(+IV0) = f0 + \Delta f \text{ und } f2 = f(-IV0)$$
$$= f0 - \Delta f$$

darstellen.

Die höhere Frequenz f1 ist eine Funktion des positiven Vormagnetisierungsstroms $+IV0$ und die niedrigere Frequenz f2 ist eine Funktion des negativen Vormagnetisierungsstroms $-IV0$. Die Grundfrequenz des Oszillators ist hierbei f0. Durch Umpolen des Vormagnetisierungsstroms IV0 fällt bei der Differenzbildung der beiden gemessenen Frequenzen f1 und f2 die Grundfrequenz f0 heraus, und man erhält als Ausgangssignal $2 \Delta f$, das bei gegebenem Vormagnetisierungsstrom IV0 proportional der Vormagnetisierungsstromänderung ist ($2 \Delta f \sim \Delta I$). Somit erhält man ein Mass für die Stärke eines äusseren Magnetfeldes. Dabei ist der Grundwert, die Grundfrequenz f0 des Oszillators eliminiert.

Mit der in Fig. 2 gezeigten Schaltungsanordnung wird mit der Magnetsonde SON und einem LC-Oszillator OSZ die Feldstärke ermittelt. Dabei ist die Induktivität LS mit der Wicklung W der Magnetsonde SON frequenzbestimmendes Glied des Oszillators OSZ. Mit einer Frequenzmesseinrichtung FME werden die beiden Frequenzen f1 und f2 gemessen. Mit einem nachgeschalteten Subtrahierer SUB wird aus den beiden gemessenen Frequenzen f1 und f2 die Frequenzdifferenz f1–f2 gebildet und als ermittelte Feldstärke angezeigt. Die rechteckförmige Spannung wird beispielsweise durch das periodische Umpolen einer Gleichspannung UG mittels des Schaltelements S1 erzeugt. Über den Vorwiderstand RV gelangt die Spannung in den Oszillatorschaltkreis OSZ, und der abwechselnd positive und negative Vormagnetisierungsgleichstrom IV0 erzeugt abwechselnd die Frequenzen f1 und f2. Diese werden abwechselnd über das Schaltelement S2 an die zwei Eingänge der Frequenzmesseinrichtung FME geführt. Ein Taktgenerator TG steuert sowohl das periodische Umpolen der Gleichspannung UG mit dem Schaltelement S1 als auch dazu synchron das Umschalten des Schaltelementes S2. Je nach Schalterstellung gelangt die zu messende Frequenz einmal an den ersten Eingang der Frequenzmesseinrichtung FME und zum anderen Mal an den zweiten Eingang der Frequenzmesseinrichtung FME. Die Ausgänge der Frequenzmesseinrichtung sind an die Eingänge eines Subtrahierers SUB geführt. Dieser bildet aus den gemessenen Frequenzen f1 und f2 den Differenzbetrag $2 \Delta f$. Auf diese Weise wird die Grundfrequenz f0 eliminiert und nur die Frequenzdifferenz $2 \Delta f$ ermittelt. Zur Erhöhung der Messsicherheit und der Messgenauigkeit kann der Differenzbetrag $2 \Delta f$ erst aus mehreren Frequenzmessungen für die Frequenzen f1 und f2 gebildet werden. Dieser ermittelte Frequenzdifferenzbetrag ist eine Funktion der Feldstärke des äusseren Magnetfeldes und wird in einer nachgeordneten Anzeigeeinrichtung ANZ angezeigt.

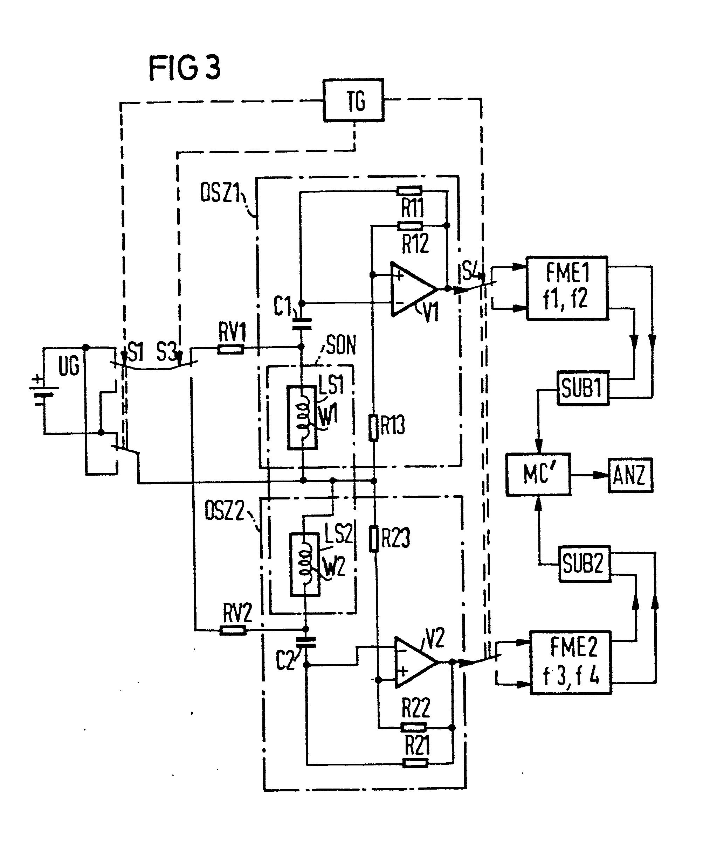

Fig. 3 zeigt eine Schaltungsanordnung zur Ermittlung der Richtung eines Magnetfeldes. Hierbei wird eine Magnetsonde SON verwendet, die erlaubt, beide Komponenten eines Magnetfeldes, d.h. die Feldvektoren, die senkrecht zueinander stehen, zu erfassen. Dazu weist die Sonde zwei Schenkel, die in einem bestimmten Winkel, beispielsweise senkrecht, zueinander stehen, mit jeweils einer Wicklung W1 und W2 auf. Die Ansteuerung dieser Schaltung erfolgt ähnlich wie in dem ersten Ausführungsbeispiel. Der Taktgenerator TG polt periodisch die Gleichspannung UG mittels des Schaltelements S1 um und legt sie über einen Vorwiderstand RV1 mittels des Schaltelementes S3 an die Wicklung W1 der Sondeninduktivität LS1 und danach über einen Vorwiderstand RV2 an die Wicklung W2 der Sondeninduktivität LS2. Hier sind zwei Oszillatoren OSZ1 und OSZ2 vorgesehen. Die Sondeninduktivität LS1 ist frequenzbestimmendes Glied des ersten Oszillators OSZ1, die Sondeninduktivität LS2 ist frequenzbestimmendes Glied des zweiten Oszillators OSZ2. Der jeweilige Ausgang der Oszillatoren ist über das Schaltelement S4 jeweils an die Eingänge zweier Frequenzmesseinrichtungen FME1 und FME2 geführt. Das Schaltelement S4 wird vom Taktgenerator TG synchron mit dem Schaltelement S1 und S3 gesteuert.

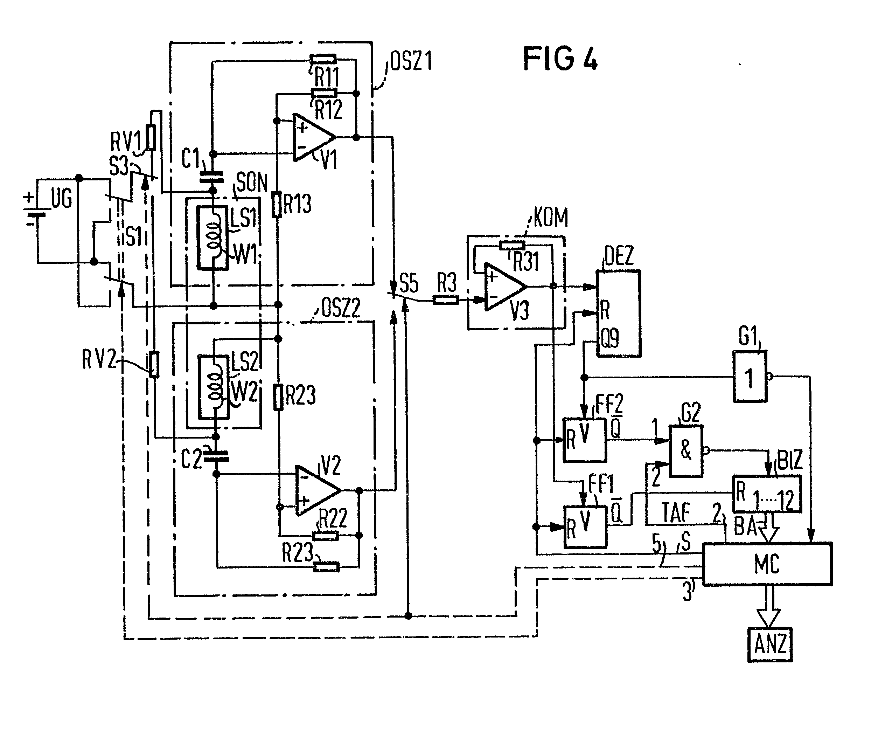

Die Fig. 4 zeigt ein abgewandeltes Ausführungsbeispiel gemäss der Fig. 3. Hierbei werden die vier verschiedenen Frequenzen f1, f2, f3 und f4 mit digitalen Zählern DEZ, BIZ gemessen und in einem handelsüblichen zweiten Mikrocomputer MC abgespeichert. Dieser kann beispielsweise ein Mikrocomputer der Firma Siemens SAB 8748 C sein. Im Mikrocomputer MC werden die Frequenzdifferenzbeträge gebildet und daraus die Feldrichtung des äusseren Magnetfeldes ermittelt. Der zweite Mikrocomputer MC übernimmt auch die Taktsteuerung der Schaltelemente S3 und S5 und der Zähler DEZ und BIZ.

Wie in Fig. 3 ist die Gleichspannungsquelle UG über die Schaltelemente S1 und S3 einmal über den Vorwiderstand RV1 an die Wicklung W1 der Sondeninduktivität LS1 und das andere Mal über den Vorwiderstand RV2 an die Wicklung W2 der Sondeninduktivität LS2 angeschlossen. Die Induktivität LS1 bestimmt die Resonanzfrequenzen f1 und f2 des ersten Oszillators OSZ1 in Abhängigkeit von der positiven bzw. negativen Gleichstromvormagnetisierung. Die Induktivität LS2 bestimmt die Resonanzfrequenzen f3 und f4 des zweiten Oszillators OSZ2 in Abhängigkeit von der positiven bzw. negativen Vormagnetisierung. Die Gleichspannungsquelle UG wird mit dem Schaltelement S1 umgepolt, das vom zweiten Mikrocomputer MC über dessen Ausgang 3 taktgesteuert wird. Entsprechend wird vom zweiten Mikrocomputer MC über dessen Ausgang 5 das Anschalten des Schaltelements S3 einmal an den Vorwiderstand RV1 und das andere Mal an den Vorwiderstand RV2 gesteuert. Das bewirkt, dass die Rechteckspannung entweder an der Wicklung W1 oder an der Wicklung W2 der Sonde SON anliegt. Jeder Oszillator OSZ1 und OSZ2 weist eine an sich bekannte Verstärkerstufe V1 bzw. V2 auf. Der jeweilige Oszillatorausgang wird wahlweise mit dem Schaltelement S5 über einen Widerstand R3 an einen Komparator KOM gelegt. Das Schaltelement S5 wird ebenfalls vom zweiten Mikrocomputer MC über den Ausgang 5 synchron zum Schaltelement S3 entsprechend taktgesteuert, so dass zum Beispiel die Resonanzfrequenz f1 des ersten Oszillators OSZ1 gemessen wird, wenn die positive Halbwelle des Vormagnetisierungsstroms +IV0 durch die Wicklung W1 der Induktivität LS1 fliesst, und die Resonanzfrequenz f2 des ersten Oszillators, wenn die negative Halbwelle des Vormagnetisierungsstroms −IV0 durch die Wicklung W1 fliesst. Dann wird die Resonanzfrequenz f3 des zweiten Oszillators gemessen, wenn die positive Halbwelle des Vormagnetisierungsstromes +IV0 durch die Wicklung W2 der zweiten Induktivität LS2 fliesst, und die Resonanzfrequenz f4 des zweiten Oszillators OSZ2, wenn die negative Halbwelle des Vormagnetisierungsstroms −IV0 durch die Wicklung W2 der Induktivität LS2 fliesst.

Der Komparator KOM, zum Beispiel LM311 N von Texas Instruments, wandelt die sinusförmigen Eingangssignale in Rechtecksignale um. Diese gelangen an den Eingang des Dekadenzählers DEZ (z.B. MC14017 BCLD von Motorola) und an den Eingang des ersten Flip-Flop FF1. Der Ausgang des Dekadenzählers DEZ ist mit dem Eingang des zweiten Flip-Flop FF2 und über ein Nichtglied G1 mit dem zweiten Mikrocomputer MC verbunden. Der Ausgang Q̄ des zweiten Flip-Flop FF2 führt auf den ersten Eingang eines NAND-Gliedes G2, das am zweiten Eingang mit einer Taktfrequenz TAF von z.B. 666 kHz beaufschlagt ist. Diese Taktfrequenz TAF wird vom zweiten Mikrocomputer MC erzeugt und über dessen Ausgang 2 abgegeben. Der Ausgang des NAND-Gliedes G2 ist mit dem Binärzähler BIZ verbunden. Dieser kann ein handelsüblicher Zähler, z.B. NC14040 BCL von Motorola, mit 12-bit-Binärausgängen sein. Zur Rücksetzung der beiden Flip-Flop FF1 und FF2 und des Dekadenzählers DEZ sind deren «Reset»-Eingänge R mit dem Ausgang S des zweiten Mikrocomputers MC verbunden. Der Ausgang Q̄ des ersten Flip-Flop FF1 führt auf den «Reset»-Eingang R des Binärzählers BIZ. Die Binär-Ausgänge BA des Binärzählers BIZ führen auf die entsprechenden Eingänge des zweiten Mikrocomputers MC.

Mit dem «Reset»-Signal des zweiten Mikrocomputers MC an dessen Ausgang S wird das Startsignal für einen Messzyklus gegeben, um die Frequenz am Ausgang des Komparators KOM zu messen. Wird z.B. die Frequenz f1 gemessen, so wird mit der ersten ansteigenden Flanke der Frequenz f1 der Ausgang Q̄ des ersten Flip-Flop FF1 «0» und damit der «Reset»-Eingang des Binärzählers «0». Der Binärzähler BIZ ist zählbereit. Mit der ersten Flanke der Frequenz f1 zählt der Binärzähler BIZ in 666 kHz-Impulsen. Mit der 10. Flanke der Frequenz f1 steht am Ausgang Q9 des Dekadenzählers DEZ eine logische «1», die über das zweite Flip-Flop FF2 das NAND-Glied G2 sperrt, so dass keine 666 kHz-Impulse in den Binärzähler BIZ gelangen können. An den Binärausgängen BA des Binärzählers BIZ steht nun die Anzahl der gezählten 666 kHz-Impulse während 10 Perioden der Frequenz f1 im Binärcode. Da gleichzeitig mit dem Signal «1» am Ausgang Q9 des Dekadenzählers DEZ über das Nichtglied G1 eine Unterbrechung des Zählvorgangs ausgelöst wird, wird der Binärwert von den Binärzählerausgängen BA in den zweiten Mikrocomputer MC eingelesen und abgespeichert.

Ebenso werden die Frequenzen f2 bis f4 gemessen und in den zweiten Mikrocomputer MC eingespeichert. Die aus den gemessenen Frequenzen vom zweiten Mikrocomputer ermittelte Feldrichtung wird in einer dem zweiten Mikrocomputer nachgeschalteten Anzeigeeinrichtung ANZ angezeigt.

**Patentansprüche**

1. Anordnung zur Bestimmung der Feldstärke eines Magnetfeldes mit einem Oszillatorschaltkreis (OSZ), der als frequenzbestimmende Induktivität (LS) die Wicklung (W) einer Magnetfeldsonde (SON) aufweist, so dass die Frequenz des Oszillatorschaltkreises (OSZ) abhängig von der Stärke des die Sonde (SON) beaufschlagenden Magnetfeldes ist, mit einer Frequenzmesseinrichtung (FME) zur Ermittlung der Feldstärke durch Frequenzmessung und mit einer nachgeschalteten Anzeigeeinrichtung (ANZ), dadurch gekennzeichnet, dass ein erstes von einem Taktgenerator (TG) gesteuertes Schaltelement (S1) vorgesehen ist, mit dem die Spannung einer Gleichspannungsquelle (UG) periodisch umgepolt und als rechteckförmige Erregerspannung an die Wicklung (W) der Magnetfeldsonde (SON) angeschaltet ist, dass am Ausgang des Oszillatorschaltkreises (OSZ) ein zweites Schaltelement (S2) vorgesehen ist, mit dem synchron zum ersten Schaltelement (S1) und jeweils in abwechselnd aufeinanderfolgenden Zeitintervallen die für die eine Polarität der Erregerspannung auftretende Frequenz ($f_1$) einem ersten Eingang der Frequenzmesseinrichtung (FME) und die für die andere Polarität der Erregerspannung auftretende Frequenz ($f_2$) einem zweiten Eingang der Frequenzmesseinrichtung (FME) zugeführt ist, und dass ein Subtrahierer (SUB) der Frequenzmesseinrichtung (FME) zur Differenzbildung der Frequenzen (f1 und f2) nachgeschaltet ist.

2. Anordnung nach Anspruch 1, dadurch gekennzeichnet, dass ein weiterer Oszillatorschaltkreis (OSZ1 bzw. OSZ2) vorgesehen ist, der als frequenzbestimmende Induktivität (LS1 bzw. LS2) eine weitere Wicklung (W1 bzw. W2) der Magnetfeldsonde (SON) aufweist, wobei die weitere Wicklung (W1 bzw. W2) zu der ersten in einem bestimmten Winkel steht, dass ein drittes, von dem Taktgenerator (TG) gesteuertes Schaltelement (S3) vorgesehen ist, mit dem die rechteckförmige Erregerspannung abwechselnd an eine der beiden Wicklungen (W1 bzw. W2) der beiden Oszillatorschaltkreise (OSZ1, OSZ2) geschaltet ist, dass dem weiteren Oszillatorschaltkreis (OSZ1 bzw. OSZ2) eine weitere Frequenzmesseinrichtung (FME1 bzw. FME2) mit einem weiteren, nachgeschalteten Subtrahierer (SUB1 bzw. SUB2) nachgeschaltet ist, dessen jeweiliger Ausgang mit einem ersten Mikrocomputer (MC') verbunden ist, der die Richtung des Magnetfeldes ermittelt und mit einer nachgeordneten Anzeigeeinrichtung (ANZ) anzeigt, und dass am Ausgang jedes Oszillatorschaltkreises (OSZ1, OSZ2) ein viertes Schaltelement (S4) vorgesehen ist, mit dem synchron zum ersten Schaltelement (S1) und in Abhängigkeit von der Schalterstellung des dritten Schaltelements (S3) die Frequenzen (f1 und f2) des ersten Oszillatorschaltkreises (OSZ1) und die Frequenzen (f3 und f4) des weiteren Oszillatorschaltkreises (OSZ2) abwechselnd den beiden Frequenzmesseinrichtungen (FME1 und FME2) zugeführt sind.

3. Anordnung nach Anspruch 2, dadurch gekennzeichnet, dass der Taktgenerator (TG), die Subtrahierer (SUB1, SUB2) und auch der erste Mikrocomputer (MC') zur Ermittlung der Magnetfeldrichtung von einem zweiten Mikrocomputer (MC) gebildet sind, und dass die Frequenzmesseinrichtungen (FME1, FME2) einen Komparator (KOM), mindestens zwei Flip-Flop (FF1, FF2) und zumindest einen digitalen Zähler (DEZ, BZ) aufweisen, die vom zweiten Mikrocomputer (MC) steuerbar sind.

## Claims

1. An arrangement for determining the field strength of a magnetic field, with an oscillator circuit (OSZ) provided with the winding (W) of a magnetic field probe (SON) as a frequency-determining inductance (LS), so that the frequency of the oscillator circuit (OSZ) is dependent upon the strength of the magnetic field which acts upon the probe (SON), a frequency measuring device (FME) to determine the field strength by frequency measurement, followed by a display device (ANZ), characterised in that a first switching element (S1) controlled by a clock pulse generator (TG) periodically reverses the polarity of a d.c. voltage source (UG) and is connected to the winding (W) of the magnetic field probe (SON) to provide a rectangular excitation voltage, that a second switching element (S2) is arranged at the output of the oscillator circuit (OSZ) to act in synchronism with the first switching element (S1) and in each case in alternating consecutive time intervals the frequency ($f_1$) which occurs for the first polarity of the excitation voltage is fed to a first input of the frequency measuring device (FME) and the frequency ($f_2$) which occurs for the other polarity of the excitation voltage is fed to a second input of the frequency measuring device (FME), and that a subtractor (SUB) is connected to the output end of the frequency measuring device (FME) in order to form the difference between the frequencies (f1 and f2).

2. An arrangement as claimed in Claim 1, characterised in that there is provided a further oscillator circuit (OSZ1 or OSZ2 as the case may be) which possesses a further winding (W1 or W2 as the case may be) of the magnetic field probe (SON) as a frequency-determining inductance (LS1 or LS2 as the case may be), where the further winding (W1 or W2) is arranged at a specific angle to the first winding, that a third switching element (S3) is controlled by the clock pulse generator (TG) and alternately connects the rectangular excitation voltage to one of the two windings (W1 or W2) of the two oscillator circuits (OSZ1, OSZ2), that the further oscillator circuit (OSZ1 or OSZ2) is connected at its output end to a further frequency measuring device (FME1 or FME2 as the case may be) which is itself followed by a subtractor (SUB1 or SUB2 as the case may be), the output of each of which is connected to a first microcomputer (MC') which determines the direction of the magnetic field and displays it on a following display device (ANZ), and that at the output of each oscillator circuit (OSZ1, OSZ2) there is arranged a fourth switching element (S4) with which, in synchronism to the first switching element (S1) and in dependence upon the switch position of the third switching element (S3), the frequences (f1 and f2) of the first oscillator circuit (OSZ1) and the frequencies (f3 and f4) of the further oscillator circuit (OSZ2) are alternately fed to the two frequency measuring devices (FME1 and FME2).

3. An arrangement as claimed in Claim 2, characterised in that the clock pulse generator (TG), the subtractors (SUB1, SUB2) and the first microcomputer (MC') which serves to determine the direction of the magnetic field are formed by a second microcomputer (MC), and that the frequency measuring devices (FME1, FME2) possess a comparator (KOM), at least two flip-flops (FF1, FF2) and at least one digital counter (DEZ, BZ) which can be controlled by the second microcomputer (MC).

## Revendications

1. Dispositif pour déterminer l'intensité d'un champ magnétique comportant un circuit oscillateur (OSZ), qui comporte en tant qu'inductance (ES) déterminant la fréquence, l'enroulement (W) d'une sonde (SON) du champ magnétique, de sorte que la fréquence du circuit oscillateur (SZ) dépend de l'intensité du champ magnétique chargeant la sonde (SON), et comportant un fréquencemètre (FME) servant à déterminer l'intensité de champ par mesure de la fréquence, et un dispositif d'affichage (AMZ) branché en aval, caractérisé par le fait qu'il est prévu un premier organe de commutation (S1) commandé par un générateur de cadence (TG) et à l'aide duquel la tension d'une source de tension continue (UG) subit une inversion périodique de polarité, cette tension étant appliquée en tant que tension d'excitation de forme rectangulaire à l'enroulement (W) de la sonde de champ magnétique (SEN), qu'il est prévu, à la sortie du circuit oscillateur (OSZ) un second organe de commutation (S2) avec lequel, en synchronisme avec le premier organe de commutation (S1) et respectivement pendant des intervalles de temps se succédant de façon alternée, la fréquence (f1), qui apparaît pour une polarité de la tension d'excitation, est envoyée à une première entrée du fréquencemètre (FME) et la fréquence (f2), qui apparaît pour l'autre polarité de la tension d'excitation, est envoyée à une seconde entrée du fréquencemètre (FME), et qu'un dispositif soustracteur (SUB) est branché en aval du fréquencemètre (FME), en vue de former la différence entre les fréquences (f1 et f2).

2. Dispositif suivant la revendication 1, caractérisé par le fait qu'il est prévu un autre circuit oscillateur (OSZ1 ou OSZ2) qui comporte, comme inductance (LS1 ou LS2) déterminant la fréquence, un enroulement supplémentaire (W1 ou W2) de la sonde (SON) du champ magnétique, l'enroulement supplémentaire (W1 ou W2) faisant par rapport au premier enroulement un angle déterminé, qu'il est prévu un troisième organe de commutation (S3) commandé par le générateur de cadence (TG) et à l'aide duquel la tension d'excitation rectangulaire est appliquée en alternance à l'un des deux enroulements (W1 ou W2) des deux circuits oscillateurs (OSZ1, OSZ2), qu'en aval du circuit oscillateur supplémentaire (OSZ1 ou OSZ2) se trouve branché un fréquencemètre supplémentaire (FME1 ou FME2) en aval duquel est branché un dispositif soustracteur supplémentaire (SUB1 ou SUB2) et dont la sortie respective est reliée à un premier micro-ordinateur (MC'), qui détermine la direction du champ magnétique et l'affiche au moyen d'un dispositif d'affichage (ANZ) monté en aval, et qu'il est prévu, à la sortie de chaque circuit oscillateur (OSZ1, OSZ2), un quatrième organe de commutation (S4) à l'aide duquel les fréquences (f1 et f2) du premier circuit oscillateur (OSZ1) et les fréquences (f3 et f4) du circuit oscillateur supplémentaire (OSZ2) sont envoyées en alternance aux deux fréquencemètres (FME1 ou FME2) et ce en synchronisme avec le premier organe de commutation (S1) et en fonction de la position de commutation du troisième organe de commutation (S3).

3. Dispositif suivant la revendication 2, caractérisé par le fait que le générateur de cadence (TG), les dispositifs soustracteurs (SUB1, SUB2) et également le premier micro-ordinateur (MC') servant à déterminer la direction du champ magnétique sont formés par un second micro-ordinateur (MC), et que les fréquencemètres (FME1, FME2) comportent un comparateur (KOM), au moins deux bascules bistables (FF1, FF2) et au moins un compteur numérique (DEZ, BZ), qui peuvent être commandés par le second micro-ordinateur (MC).

# FIG 1

# FIG 2

# FIG 3

FIG 4

0 045 509